(19) Europäisches Patentamt
European Patent Office
Office européen des brevets

(11) Numéro de publication: **0 196 239 B1**

# (12) FASCICULE DE BREVET EUROPEEN

(45) Date de publication du fascicule du brevet: **28.03.90**

(51) Int. Cl.⁴: **H03C 1/02**, H04B 14/02, H03F 1/32

(21) Numéro de dépôt: **86400296.9**

(22) Date de dépôt: **11.02.86**

(54) **Dispositif précorrecteur du signal audiofréquence dans une chaine de modulation d'impulsions en largeur d'émetteur de signaux radioélectriques à modulation d'amplitude.**

(30) Priorité: **15.02.85 FR 8502248**

(43) Date de publication de la demande: **01.10.86 Bulletin 86/40**

(45) Mention de la délivrance du brevet: **28.03.90 Bulletin 90/13**

(84) Etats contractants désignés: **CH DE GB LI**

(56) Documents cités:
**DE-C- 3 221 911**
**FR-A- 2 397 103**

(73) Titulaire: **THOMSON-CSF, 51, Esplanade du Général de Gaulle, F-92800 Puteaux(FR)**

(72) Inventeur: **Rebernak, William, THOMSON-CSF SCPI 19, avenue de Messine, F-75008 Paris(FR)**

(74) Mandataire: **Lincot, Georges et al, THOMSON-CSF SCPI, F-92045 PARIS LA DEFENSE CEDEX 67(FR)**

EP 0 196 239 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un dispositif précorrecteur du signal audiofréquence dans une chaîne de modulation d'impulsions en largeur d'émetteur de signaux radioélectriques à modulation d'amplitude. Un tel dispositit est décrit dans le document FR-A 2 397 103.

Dans certains émetteurs d'ondes radioélectriques à modulation d'amplitude, le signal audiofréquence de modulation est converti en impulsions modulées en largeur et le train d'impulsions obtenu à la sortie du modulateur est transmis à un tube découpeur par l'intermédiaire d'une fibre optique, afin d'obtenir un bon isolement galvanique entre l'étage convertisseur et le tube découpeur qui se trouve à un potentiel flottant par rapport à la masse générale de l'émetteur. La sortie de la fibre optique est reliée à un amplificateur transistorisé qui a pour but de produire les impulsions nécessaires à l'excitation du tube découpeur pour le faire fonctionner en hacheur de tension. La cathode du tube découpeur est reliée à un filtre passe-bas pour reconstituer le signal audiofréquence avant de l'appliquer à la sortie de l'amplificateur haute fréquence qui engendre l'onde porteuse du signal audiofréquence à transmettre.

Le signal audiofréquence qui est ainsi amplifié présente une forte distorsion spécialement lorsque les taux de modulation sont importants. Dans ces cas, en effet, les impulsions sont soit très fines ou très larges et comme la capacité d'entrée relativement importante des tubes découpeurs augmente les temps de montée et de descente des impulsions, certaines impulsions très fines sont éliminées.

D'autre part, le tube découpeur a un fonctionnement différent suivant qu'il se trouve dans l'état conducteur ou bloqué, ceci étant dû pour une part, à la dissymétrie entre la charge et la décharge du condensateur entre la grille et le circuit de masse et pour une autre part, à la présence de la diode dite "de roue libre" qui referme le circuit à la masse lorsque le tube est bloqué.

Enfin, la distorsion augmente avec la fréquence de modulation du fait même du principe de la modulation à largeur d'impulsion qui est utilisée.

Le but de l'invention est de pallier les inconvénients précités.

A cet effet, l'invention a pour objet, un dispositif précorrecteur du signal audiofréquence dans une chaîne de modulation d'impulsions en largeur d'émetteur de signaux radioélectriques à modulation d'amplitude caractérisé en ce qu'il comprend un dispositif convertisseur du signal audiofréquence en échantillons numériques, des moyens de traitement numérique couplés à la sortie du dispositif convertisseur pour calculer des largeurs d'impulsions en fonction de l'amplitude des échantillons numériques fournis par le dispositif convertisseur du signal audiofréquence, des moyens de mémorisation adressés par les moyens de traitement et contenant pour chaque largeur d'impulsion calculée par les moyens de traitement une largeur correspondante corrigée, et un registre calibreur d'impulsions commandé par les moyens de mémorisation pour fournir sortie des impulsions dont la largeur correspond à la valeur de chaque largeur d'impulsion corrigée lue dans les moyens de mémorisation.

Référence est faite aussi au document DE-C 3 221 911 qui décrit un amplificateur à haute fréquence avec un dispositif de modulation dans lequel le signal de modulation est mis en forme préalablement pour compenser la distortion dans les étanges d'amplification et de modulation. a mise en forme est effectuée numériquement et est leasée sur une comparaison d'un signal détecté avec un signal de consigne mémorisé.

D'autres caractéristiques et avantages de l'invention apparaîtront à l'aide de la description faite au regard des dessins annexés donnés uniquement à titre d'exemple et dans lesquels:

- la figure 1 représente une chaîne d'émission d'un signal audiofréquence converti en impulsions modulées en largeur, selon l'art connu,
- la figure 2 un diagramme représentatif de la réponse à un signal audiofréquence sinusoïdal de la chaîne d'émission de la figure 1,
- la figure 3 un schéma synoptique du dispositif de précorrection selon l'invention,
- la figure 4 un mode de réalisation des moyens de traitement représentés à la figure 3.

La chaîne d'émission de l'art connu représentée à la figure 1 comprend, d'une part, une chaîne de modulation d'impulsions en largeur constituée par un convertisseur 1 de signaux audiofréquence en impulsions modulées en largeur, une fibre optique 2, un amplificateur 3, un tube découpeur 4, et d'autre part, un filtre passe-bas 5 pour reconstituer le signal audiofréquence à partir des signaux hachés par le tube découpeur, et un tube amplificateur haute fréquence 6 relié par l'anode à la sortie du filtre passe-bas 5. Le point de liaison commun entre la sortie du filtre passe-bas 5 et l'anode du tube amplificateur haute fréquence 6 est relié à l'entrée d'un adaptateur d'antenne 7 qui est lui-même relié par sa sortie à une antenne 8. Le point commun reliant l'entrée du filtre passe-bas 5 à la cathode du tube découpeur 4 est relié à la masse générale d'alimentation de l'émetteur au travers d'une diode 9 et d'une self de choc 10. Dans cette réalisation les tubes 4 et 6 sont reliés en cascade, la cathode du tube 4 étant reliée à l'anode du tube 6 au moyen du filtre passe-bas 5. La cathode du tube 6 est reliée à la masse d'alimentation générale du circuit de l'émetteur et l'anode du tube 4 est reliée à la haute tension d'alimentation +U de l'émetteur au travers d'une self de choc 11. Le signal audiofréquence de modulation de l'émetteur est appliqué à l'entrée du convertisseur 1 pour être échantillonné et converti en impulsions de fréquence fixe et de rapport cyclique variable en fonction de l'amplitude de chaque échantillon fixe. Le train d'impulsions obtenu à la sortie du convertisseur 1 est appliqué à l'entrée de l'amplificateur 3 au moyen de la fibre optique 2 qui opère l'isolement galvanique entre l'étage convertisseur 1 et le tube découpeur 4. L'amplificateur 3 amplifie les impulsions de fréquence fixe et de rapport cyclique

variable pour exciter la grille du tube 4 de manière à le faire fonctionner en hacheur de tension. Le filtre passe-bas 5 restitue la valeur moyenne du signal modulé en largeur, amplifié par le tube 4 ainsi obtenu et applique ce signal sur l'anode du tube amplificateur haute fréquence 6 ce qui a pour effet, de moduler en amplitude le signal haute fréquence engendré par le tube 6 à l'entrée de l'adaptateur d'antenne 7 pour alimenter l'antenne 8. Dans le mode de réalisation de la figure 1 le signal audiofréquence qui est amplifié par la chaîne constituée des éléments 1 à 5 présente une forte distorsion qui est d'autant plus importante que le taux de modulation est important, cette distorsion se manifestant par une déformation du signal audiofréquence reconstitué, de la manière représentée à la figure 2 qui montre la réponse B de la chaîne d'amplification à un signal sinusoïdal audiofréquence A appliqué à l'entrée de la chaîne d'amplification.

Le dispositif de précorrection selon l'invention qui est représenté par le schéma synoptique de la figure 3 permet de remédier à ces inconvénients. Ce dispositif se substitue au dispositif convertisseur 1 de la chaîne de modulation représentée à la figure 1 et a pour fonction de définir des valeurs de largeurs d'impulsions corrigées pour qu'à la sortie du filtre 5 de la chaîne d'amplification, le signal audiofréquence obtenu ait une allure similaire à celle du signal audiofréquence appliqué à son entrée. Le dispositif de précorrection de la figure 3 comprend, d'une part, un convertisseur analogique-numérique 12 couplé par ses entrées de commande à une horloge d'échantillonnage 13 et par sa sortie à des moyens de traitement 14 et comprend, d'autre part, des moyens de mémorisation 15 de données de correction adressés par les moyens de traitement 14 et couplés par leurs sorties à un dispositif calibreur d'impulsions 16, formé par un registre ou tout autre moyen équivalent susceptible de fournir des impulsions de rapport cyclique variable à la fréquence de découpage du tube découpeur 4. Le signal audiofréquence qui est appliqué à l'entrée du convertisseur analogique-numérique 12 est échantillonné à une fréquence très supérieure à la fréquence de découpage du tube découpeur 4. Les échantillons numériques obtenus à la sortie du convertisseur analogique-numérique 12 sont appliqués à l'entrée des moyens de traitement 14 qui calculent la valeur moyenne des échantillons qui lui sont transmis à l'intérieur de chaque période de découpage du tube découpeur 4 pour déterminer la largeur théorique de l'impulsion correspondant aux valeurs numériques de ces échantillons. Les moyens de traitement 14 déterminent également la gamme de fréquences du signal audiofréquence qui est appliquée à l'entrée du convertisseur analogique-numérique 12 en analysant la progression de la valeur des échantillons qui lui sont transmis. Par une analyse séquentielle de ces échantillons les moyens de traitement 14 définissent également le sens croissant ou décroissant du signal audiofréquence.

La valeur théorique de la largeur d'impulsion calculée par les moyens de traitement 14 est appliquée aux entrées d'adressage des moyens de mémorisation 15 pour pointer à l'intérieur des moyens de mémorisation 15 une largeur d'impulsion corrigée correspondante. Ces valeurs de correction qui sont mémorisées à l'intérieur des moyens de mémorisation 15 sont déterminées au moment de la mise en service de chaque configuration d'émetteur en fonction des niveaux de modulation du signal audiofréquence, d'un nombre déterminé de gammes de fréquence du signal audiofréquence, du front croissant ou décroissant du signal audiofréquence et du tube découpeur utilisé. Ces valeurs de correction sont enregistrées par exemple sous la forme de 2 N tables correspondant à un nombre limité de N gammes de fréquences du signal audiofréquence appliqué à l'entrée de l'émetteur pour reproduire correctement le signal de modulation. Les 2 N tables sont réparties à l'intérieur des moyens de mémorisation 15 dans deux mémoires de correction 17 et 18 représentées sur la figure 3. La mémoire 17 est destinée à contenir les N tables de correction correspondant aux fronts montants du signal audiofréquence et la mémoire de correction 18 est destinée à contenir les N tables de correction correspondant par exemple aux fronts descendants du signal audiofréquence. Les contenus des mémoires de correction 17 et 18 sont appliqués au rythme de la fréquence de récurrence du signal modulé en largeur sur l'entrée du dispositif calibreur d'impulsions 16 qui fournit sur sa sortie une impulsion dont la largeur correspond à celle de la valeur fournie par une des mémoires de correction 17 ou 18.

Un exemple de réalisation des moyens de traitement 14 est représenté à la figure 4. Les moyens de traitement représentés à la figure 4 comprennent, représentés à l'intérieur de rectangles en pointillés, des moyens 19 de calcul de la valeur absolue de la largeur d'impulsion théorique correspondant à une suite d'échantillons numériques $U_i$ fournie par le convertisseur analogique-numérique 12 de la figure 3, des moyens de calcul 20 du sens de variation croissant ou décroissant du signal audiofréquence appliqué à l'entrée du convertisseur analogique-numérique 12 et des moyens 21 de détection de la fréquence du signal audiofréquence appliqué à l'entrée du convertisseur analogique-numérique.

Les moyens de calcul 19 comprennent, également représentés à l'intérieur de rectangles en pointillés, un premier dispositif 22 de calcul de la valeur moyenne de chaque N+1 échantillons apparaissant durant une période de récurrence des signaux de fréquence constante modulés en largeur appliqués à l'entrée du tube découpeur 4 de la figure 1 et un dispositif 23 de calcul de l'écart moyen entre le premier échantillon d'ordre zéro et le dernier échantillon d'ordre N pris à l'intérieur d'une période de récurrence du signal modulé en largeur appliqué à l'entrée du tube découpeur 4. Les moyens de calcul 19 comprennent également un soustracteur 28 et une mémoire morte programmable 29. Le soustracteur 28 possède deux entrées d'opérandes, une première entrée d'opérande est reliée à la sortie du dispositif de calcul 22 et une deuxième entrée d'opérande est reliée à la sortie du dispositif de calcul de l'écart moyen 23. La mémoire morte programmable 29 comprend deux entrées d'adressage, une première entrée d'adressage est reliée à la sortie du soustracteur 28 et une deuxième entrée d'adressage est reliée à la sortie du dispositif 22 de calcul de la valeur moyenne des impulsions. La sortie de la mémoire PROM 29 fournit sur une ligne d'adresses A1 la valeur théorique de la largeur d'impulsion calculée par le moyen de calcul 19 et applique cette valeur aux entrées d'adressage des mémoires de correction 17 et 18 de la figure 3. Le dispositif de calcul 22 de la valeur moyenne des impulsions pendant une période de récurrence des signaux modulés en largeur appliqués à l'entrée du tube découpeur 4 comprend un circuit additionneur 24 et un circuit diviseur 25. Le circuit additionneur 24 est constitué par un registre accumulateur qui accumule les valeurs numériques des N+1 échantillons fournis par le convertisseur numérique-analogique 12 durant chaque période de récurrence du signal modulé en largeur fourni à l'entrée du tube découpeur 4. Le résultat cumulé

$$\sum_{i=0}^{N} U_i$$

des N+1 valeurs d'échantillons $U_i$ dans le registre accumulateur 24 est appliqué à l'entrée du circuit diviseur 25 par N+1 qui fournit sur sa sortie la valeur moyenne

$$\frac{1}{N+1} \sum_{i=0}^{N} U_i$$

des échantillons $U_i$ fournis par le convertisseur numérique-analogique 12 durant chaque période de récurrence et applique ce résultat sur la première entrée d'opérande du soustracteur 28 et sur la première ligne d'adresse de la mémoire morte programmable 29. Le dispositif de calcul de l'écart moyen 23 comprend un soustracteur 26 qui détermine la différence d'amplitude existant à l'intérieur d'une période de récurrence entre l'échantillon $U_N$ d'ordre N et le premier échantillon $U_0$ d'ordre 0, la différence $U_N - U_0$ est appliquée à l'entrée d'un circuit diviseur par deux 27 et le résultat

$$\frac{U_N - U_0}{2}$$

de la division effectuée par le circuit diviseur 27 est appliqué sur la deuxième entrée d'opérande du circuit soustracteur 28. Le circuit soustracteur 28 calcule la valeur absolue de la différence des résultats fournis par les circuits diviseurs 25 et 27 et le résultat de la soustraction

$$\left| \frac{U_N - U_0}{2} - \frac{1}{N+1} \sum_{i=0}^{N} U_i \right|$$

est appliqué sur la deuxième entrée d'adressage de la mémoire morte programmable 29.

Les moyens de calcul 20 du sens de variation du signal audiofréquence comprennent un circuit soustracteur 30 et un compteur-décompteur 31. Le circuit soustracteur 30 calcule la différence d'amplitude existant entre deux échantillons successifs $U_{i+1}$ et $U_i$ et la différence $U_{i+1}$obtenue est enregistrée à l'intérieur d'un registre accumulateur 31 dont le contenu croissant ou décroissant est appliqué sur une ligne d'adressage A2 pour adresser la mémoire de correction 17, lorsque la différence entre deux échantillons successifs est positive ou la mémoire de correction 18 lorsque cette différence est négative. Les moyens de détection de fréquence 21 comprennent, en commun avec les moyens de calcul du sens de variation du signal audiofréquence 20, le soustracteur 30 et comprennent en plus un registre accumulateur 32 qui accumule durant plusieurs périodes de récurrence les résultats fournis par le circuit soustracteur 30, le résultat obtenu,

$$\sum_{j=1}^{M} \left| U_{i+1} - U_i \right|$$

j est appliqué sur une ligne d'adressage A3 des mémoires de correction 17 et 18 pour sélectionner à l'intérieur de celle-ci les tables de correction correspondantes.

## Revendications

1. Dispositif précorrecteur du signal audiofréquence dans une chaîne de modulation (2, 3, 4) d'impulsions en largeur d'émetteur de signaux radioélectriques à modulation d'amplitude, caractérisé en ce qu'il comprend un dispositif convertisseur (12) du signal audiofréquence en échantillons numériques, des moyens de traitement numérique (11) couplés à la sortie du dispositif convertisseur (12) pour calculer des largeurs d'impulsions en fonction de l'amplitude des échantillons numériques fournis par le dispositif convertisseur (12) du signal audiofréquence, des moyens de mémorisation (15) adressés par les moyens de traitement et contenant pour chaque largeur d'impulsion calculée par les moyens de traitement une largeur correspondante corrigée, et un dispositif calibreur d'impulsions (16) commandé par les moyens de mémorisation pour fournir des impulsions dont la largeur correspond à la valeur de chaque largeur d'impulsion corrigée lue dans les moyens de mémorisation.

2. Dispositif selon la revendication 1 caractérisé en ce que le dispositif calibreur d'impulsion (16) est constitué par un registre décompteur.

3. Dispositif selon l'une quelconque des revendications 1 et 2 caractérisé en ce que les moyens de mémorisation (15) comprennent une première mémoire (17) pour mémoriser les largeurs d'impulsions corrigées correspondant aux fronts montants du signal audiofréquence, et une deuxième mémoire (18) pour mémoriser les largeurs d'impulsions corrigées correspondant aux fronts descendants du signal audiofréquence.

4. Dispositif selon l'une quelconque des revendications 1 à 3 caractérisé en ce que les moyens de traitement (14) comprennent des moyens (19) de calcul de la valeur absolue de la largeur d'impulsion théorique en fonction de l'amplitude d'un nombre déterminé d'échantillons fourni par le convertisseur numérique-analogique (12).

5. Dispositif selon l'une quelconque des revendications 1 à 4, caractérisé en ce que les moyens de traitement (14) comprennent également des moyens (20) de calcul du sens de variation du signal audiofréquence et des moyens (21) de détection de la fréquence du signal audiofréquence.

6. Dispositif selon les revendications 4 et 5 caractérisé en ce que les moyens de mémorisation (15) sont adressés par les sorties des moyens (19) de calcul de la valeur absolue de la largeur d'impulsion théorique, par les sorties des moyens de calcul (20) du sens de variation du signal audiofréquence et par les sorties des moyens (21) de détection de la fréquence du signal audiofréquence.

7. Dispositif selon l'une quelconque des revendications 4 à 6, caractérisé en ce que les moyens (19) de calcul de la valeur absolue de la largeur d'impulsion théorique comprennent des moyens (22) de calcul de la valeur moyenne des impulsions fournies par le convertisseur analogique-numérique (12) durant chaque période de récurrence du signal modulé en largeur fourni par la chaîne de modulation, un dispositif (25) de calcul de l'écart moyen entre le premier échantillon d'ordre zéro et le dernier échantillon d'ordre N pris à l'intérieur d'une période récurrence du signal modulé en largeur fourni par la chaîne de modulation, un soustracteur (28) couplé respectivement par deux entrées d'opérandes aux moyens (22) de calcul de la valeur moyenne des impulsions et au dispositif (23) de calcul de l'écart moyen, pour calculer la différence en valeur absolue de l'écart entre les résultats fournis par les moyens (22) de calcul de la valeur moyenne des impulsions et par le dispositif (23) de calcul de l'écart moyen, une mémoire morte programmable (29) adressées par les moyens (22) de calcul de la valeur moyenne et par la sortie du soustracteur (28) pour délivrer sur sa sortie en direction du dispositif calibreur d'impulsions (16) les valeurs d'impulsions corrigées.

## Claims

1. A precorrecting device for an audiofrequency signal in a pulse width modulation chain (2, 3 and 4) of a radioelectric AM signal transmitter, characterized in that it comprises a converter device (12) for converting the audiofrequency signal into digital samples, means (11) for digital processing coupled with the output of the converter device (12) in order to calculate the widths of the pulses as a function of the amplitude of the digital samples furnished by the audiofrequency signal converter device (12), storage means (15) addressed by processing means and containing, for each pulse width calculated by the processing means a corresponding correct width, and a pulse calibrating device (16) controlled by storage means in order to supply pulses whose width corresponds to the value of each width of a corrected pulse read in the storage means.

2. The device as claimed in claim 1, characterized in that the pulse calibrating device (16) is constituted by a down counting memory.

3. The device as claimed in claim 1 or claim 2, characterized in that the storage means (15) comprise a first memory (17) in order to store the widths of the corrected pulses corresponding to the ascending flanks of the audiofrequency signal, and a second memory (18) in order to store the corrected pulse widths corresponding to the descending flanks of the audiofrequency signal.

4. The device as claimed in any one of the preceding claims 1 through 3, characterized in that the processing means (14) comprise means (19) for the calculation of the absolute value of the theoretical pulse width as a function of the amplitude of a predetermined number of samples furnished by the digital-analog converter (12).

5. The device as claimed in any one of the preceding claims 1 through 4, characterized in that the means (14) for processing also comprise means (20) for the calculation of the direction of variation of the audiofrequency signal and means (21) for the detection of the frequency of the audiofrequency signal.

6. The device as claimed in any one of the preceding claims 4 and 5, characterized in that the storage means (15) are addressed by the outputs of the device (19) for the calculation of the absolute value of the theoretical pulse width, by the outputs of the calculation means (20) of the direction of variation of the audiofrequency signal and by the outputs of the means (21) for the detection of the frequency of the audiofrequency signal.

7. The device as claimed in any one of the preceding claims 4 through 6, characterized in that the means (19) for the calculation of the absolute value of the theoretical pulse width comprise means (22) for calculation of the mean value of the pulses furnished by the analog-digital converter (12) during each period of recurrence of the pulse width modulated signal supplied by the modulation chain, a device (25) for calculation of the mean offset between the first zero order sample and the last N order sample taken within a period of recurrence of the width modulated signal furnished by the modulation chain, a subtracter (28) coupled respectively by two operand inputs with the means (22) for the calculation of the mean pulse value and with the device (23) for calculation of the mean offset, in order to calculate the difference in absolute value of the offset between the results furnished by the means (22) for the calculation of the mean value of the pulses and by the device (23) for calculation of the mean offset, a programmable ROM (29) addressed by the means (22) for the calculation of the mean value and by the output of the subtracter (28) in order to supply at its output the values of the corrected pulses in the direction of the device (16) for calibration of pulses.

## Patentansprüche

1. Vorrichtung zur Vorkorrektur eines Tonfrequenzsignals in einer Impulsdauermodulationskette (2, 3, 4) eines Amplitudenmodulations-Funksenders, dadurch gekennzeichnet, daß sie umfaßt: eine Vorrichtung (12) zur Umsetzung des Tonfrequenzsignals in Digitalproben, Mittel zur digitalen Verarbeitung (11), die an den Ausgang der Umsetzungsvorrichtung (12) angekoppelt sind, um Impulsdauern in Abhängigkeit der Amplitude der durch die Vorrichtung (12) zur Umsetzung (12) des Tonfrequenzsignals gelieferten Digitalproben zu berechnen, Speichermittel (15), die durch die Verarbeitungsmittel adressiert werden und für jede durch die Verarbeitungsmittel errechnete Impulsdauer eine entsprechende korrigierte Dauer enthalten, sowie eine Vorrichtung (16) zur Eichung der Impulse, die durch die Speichermittel gesteuert ist, um Impulse zu liefern, deren Dauer dem Wert jeder korrigierten, in den Speichermitteln ausgelesenen Impulsdauer entspricht.

2. Vorrichtung nach Anspruch 1, dadurch gekennzeichnet, daß die Vorrichtung (16) zur Eichung der Impulse aus einem Abwärts-Zählregister besteht.

3. Vorrichtung nach einem der Ansprüche 1 oder 2, dadurch gekennzeichnet, daß die Speichermittel (15) einen ersten Speicher (17) umfassen, um die korrigierten Impulsdauern, die den Anstiegsflanken des Tonfrequenzsignals entsprechen, zu speichern, sowie einen zweiten Speicher (18) umfassen, um die korrigierten Impulsdauern, die den Abfallflanken des Tonfrequenzsignals entsprechen, zu speichern.

4. Vorrichtung nach einem der Ansprüche 1 bis 3, dadurch gekennzeichnet, daß die Verarbeitungsmittel (14) Mittel zur Berechnung des absoluten Wertes der theoretischen Impulsdauer in Abhängigkeit von der Amplitude einer bestimmten Anzahl von Proben, die durch den Digital/Analog-Umsetzer (12) geliefert werden, umfassen.

5. Vorrichtung nach einem der Ansprüche 1 bis 4, dadurch gekennzeichnet, daß die Verarbeitungsmittel (14) auch Mittel (20) zur Berechnung der Veränderungsrichtung des Tonfrequenzsignals sowie Mittel (21) zur Erfassung der Frequenz des Tonfrequenzsignals umfassen.

6. Vorrichtung nach den Ansprüchen 4 und 5, dadurch gekennzeichnet, daß die Speichermittel (15) durch die Ausgänge der Mittel (19) zur Berechnung des absoluten Wertes der theoretischen Impulsdauer, durch die Ausgänge der Mittel (20) zur Berechnung der Variationsrichtung des Tonfrequenzsignals und durch die Ausgänge der Mittel (21) zur Erfassung der Frequenz des Tonfrequenzsignals, adressiert werden.

7. Vorrichtung nach einem der Ansprüche 4 bis 6, dadurch gekennzeichnet, daß die Mittel (19) zur Berechnung des absoluten Wertes der theoretischen Impulsdauern umfassen: Mittel (22) zur Bereohnung des Durchschnittwertes der Impulse, die durch den Digital/Analog-Umsetzer (12) während jeder Folgeperiode des dauermodulierten Signals geliefert werden, das durch die Modulationskette geliefert wird, eine Vorrichtung (35) zur Berechnung der Durchschnittsabweichung zwischen der ersten Probe der Ordnung Null und der letzten Probe der Ordnung N, die innerhalb einer Folgeperiode des dauermodulierten Signals, das durch die Modulationskette geliefert wird, abgenommen wird, einen Subtrahierer (28), der mit je einem seiner zwei Operandeneingänge an die Mittel (22) zur Berechnung des Durchschnittswertes der Impulse und an die Vorrichtung (23) zur Berechnung der Durchschnittsabweichung angekoppelt ist, um den Absolutwert des Unterschiedes zwischen den durch die Mittel (22) zur Berechnung des Durchschnittswertes der Impulse und durch die Vorrichtung (23) zur Berechnung der Durchschnittsabweichung gelieferten Ergebnissen zu berechnen, einen programmierbaren Festspeicher (29), der durch die Mittel (22) zur Berechnung des Durchschnittswertes und durch den Ausgang des Subtrahierers (28) adressiert wird, um an seinem Ausgang die korrigierten Impulsewerte in Richtung der Vorrichtung zur Eichung der Impulse zu liefern.

Fig.1

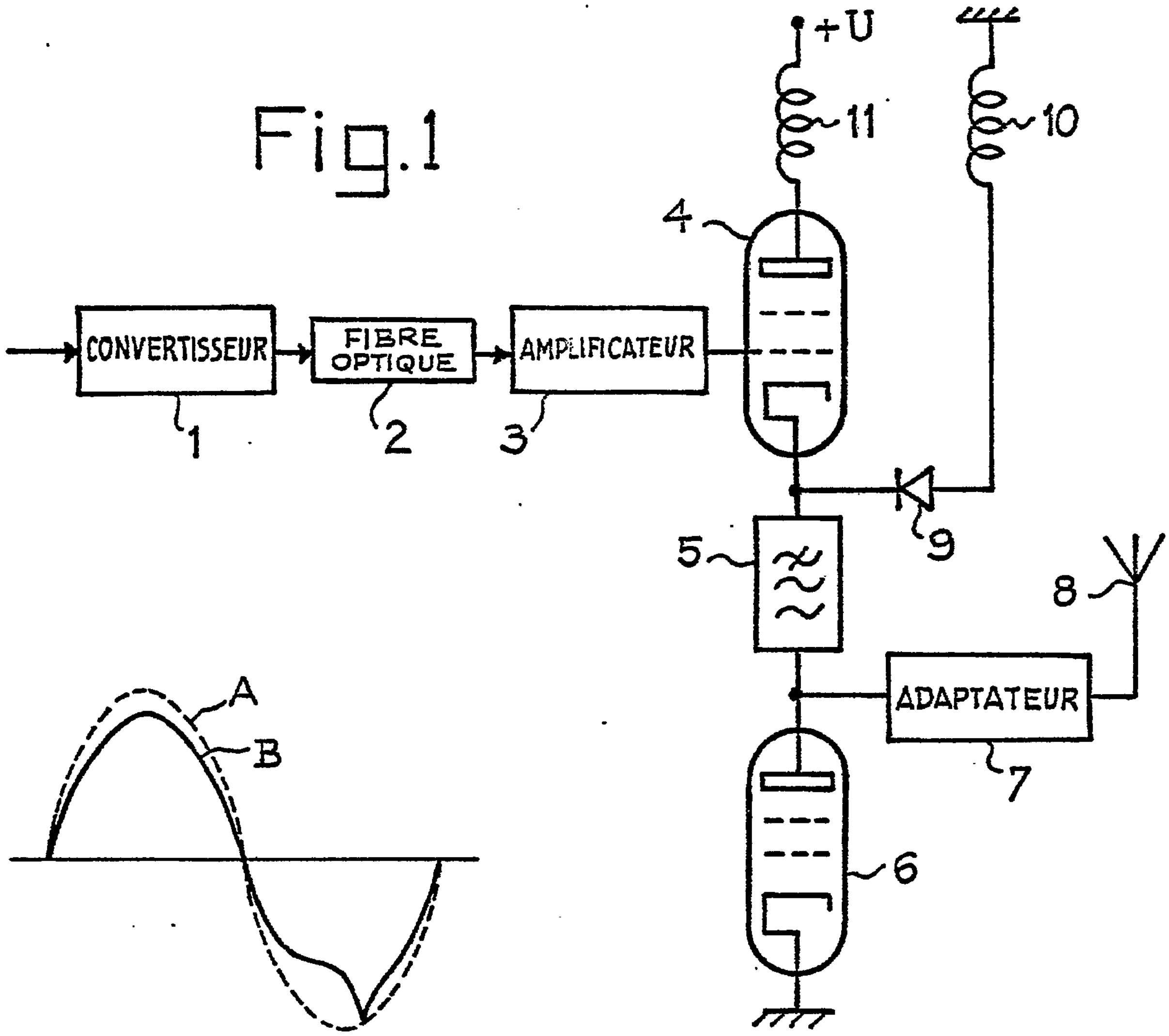


Fig.2

Fig.3

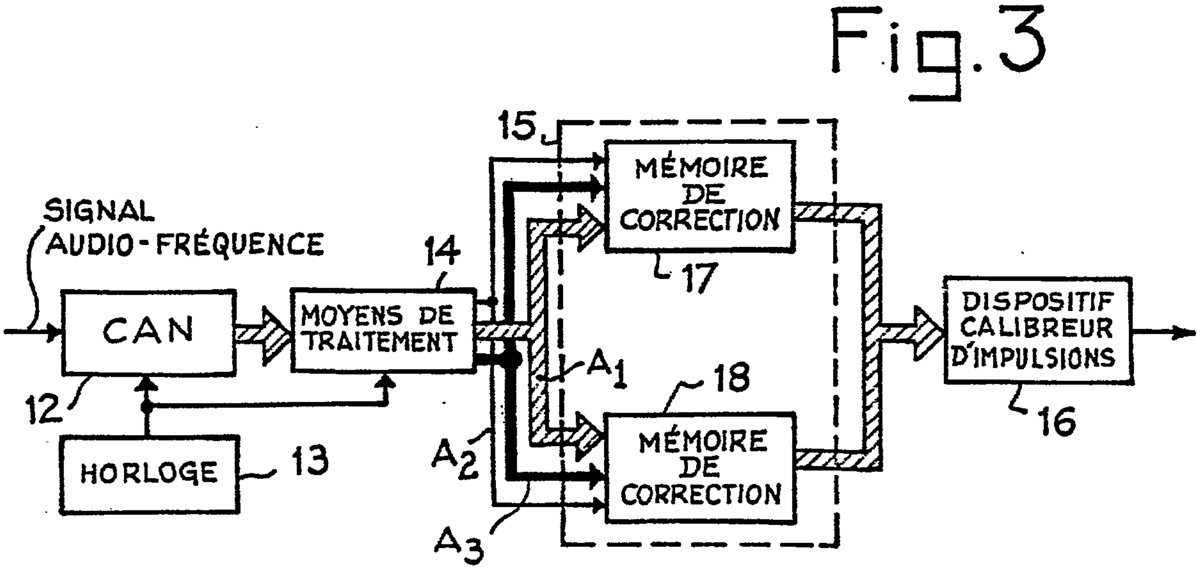

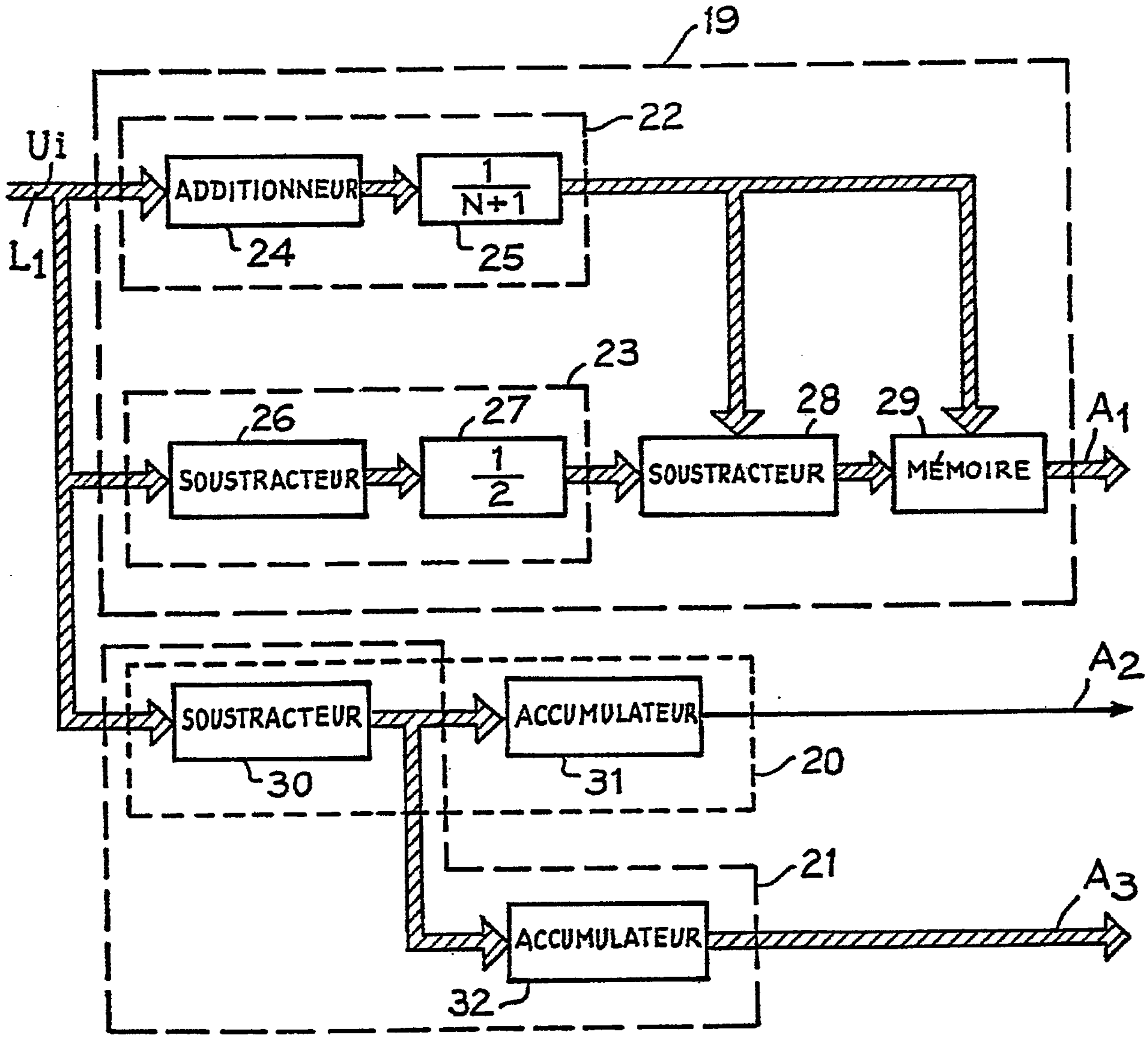
19
22
Ui
L1
ADDITIONNEUR
1
N+1
24
25
23
26
27
28
29
A1
SOUSTRACTEUR
1
2
SOUSTRACTEUR
MÉMOIRE
A2
SOUSTRACTEUR
ACCUMULATEUR
30
31
20
21
A3
ACCUMULATEUR
32

Fig.4